Europäisches Patentamt

European Patent Office

Office européen des brevets

(11) Numéro de publication: **0 222 639**
**A1**

## (12) DEMANDE DE BREVET EUROPEEN

(21) Numéro de dépôt: 86402233.0

(22) Date de dépôt: 08.10.86

(51) Int. Cl.4: **H 01 L 27/15**
H 01 S 3/19, H 01 L 31/16,
H 01 L 33/00

(30) Priorité: 14.10.85 FR 8515217

(43) Date de publication de la demande:
20.05.87 Bulletin 87/21

(84) Etats contractants désignés: **DE GB NL**

(71) Demandeur: **Bouadma, Noureddine**
**17 rue du Val de Marne**
**F-94250 Gentilly (FR)**

**Brillouet, François**
**17, rue des Fontaines**
**F-92310 Sèvres (FR)**

Kampfer, Angelika
146 rue du Théâtre
F-75015 Paris (FR)

(72) Inventeur: **Bouadma, Noureddine**
**17 rue du Val de Marne**
**F-94250 Gentilly (FR)**

**Brillouet, François**
**17, rue des Fontaines**
**F-92310 Sèvres (FR)**

**Kampfer, Angelika**
**146 rue du Théâtre**
**F-75015 Paris (FR)**

(74) Mandataire: **Mongrédien, André et al**
**c/o BREVATOME 25, rue de Ponthieu**
**F-75008 Paris (FR)**

(54) Procédé de réalisation d'une structure intégrée laser-photodétecteur.

(57) Sur un substrat (10) on dépose une couche tampon (12) et une double hétérostructure (14). On attaque une partie de la double hétérostructure pour former une face clivée (26) et dégager la couche tampon (12). Sur celle-ci on forme un photodétecteur, par exemple à l'aide d'un contact Schottky (30).

Application à la réalisation de sources lumineuses pour les télécommunications optiques.

FIG. 1

EP 0 222 639 A1

## Description

<u>Procédé de réalisation d'une structure intégrée laser-photodétecteur</u>

La présente invention a pour objet un procédé de réalisation d'une structure intégrée laser-photodétecteur.

Le domaine technique de l'invention est celui des lasers à semiconducteurs à double hétérostructure, soit classique, soit quantique (cette dernière étant désignée généralement par "multi-puits quantique") et à géométrie de jonction en forme de ruban. Une double hétérostructure est constituée d'un empilement de couches minces d'alliage semiconducteurs différents. Ces couches sont déposées sur un substrat monocristallin, soit par épitaxie en phase liquide ou gazeuse, soit par jet moléculaire. L'épaisseur de la zone active, région où sont créés à la fois les paires électrons-trous et les photons, est de l'ordre de 100 nm pour une double hétérostructure classique. Elle est réduite à une dizaine de nanomètres dans le cas d'une structure quantique.

Pour les lasers émettant entre 0,8 et 0,9 μm. les couches constituant la double hétérostructure sont en alliage $Ga_{1-x}Al_xAs$, tandis que pour les lasers émettant entre 1,3 et 1,65 μ les couches sont en alliage $Ga_{1-x}In_xAs_{1-y}P_y$.

En télécommunications par fibre optique, domaine privilégié des lasers à semiconducteurs, la puissance émise par les lasers est sensible aux fluctuations de température et aux dégradations partielles dues à une longue durée de fonctionnement. Il est donc nécessaire de stabiliser en puissance l'émetteur laser. Cette stabilisation est obtenue par un photodétecteur placé à l'arrière du laser. Le signal détecté est injecté dans un circuit de contre-réaction qui permet de réajuster le courant d'alimentation du laser. Ce détec teur, monté. comme le laser, dans la tête optique, doit être positionné avec précision pour collecter le maximum de puissance. Lors de son montage il peut aussi être nécessaire de l'incliner pour éviter une instabilité de l'émission par réinjection de photons dans la cavité laser.

L'intégration d'un laser et d'un photodétecteur a déjà fait l'objet de travaux ces dernières années. Deux solutions ont déjà été rapportées : l'intégration monolithique et l'intégration hybride.

1. Dans la première de ces techniques, il s'agit de réaliser un canal perpendiculaire au ruban du laser par attaque chimique ou ionique de la double hétérostructure, ce qui permet de séparer deux composants : le laser d'un côté et le photodétecteur de l'autre. Les fonctions de ces deux composants sont différenciées par la polarité de la tension appliquée à la jonction p-n qu'ils comprennent tous deux : le laser voit sa jonction polarisée dans le sens passant (p-n directe), alors que le photodétecteur voit sa jonction polarisée en inverse. Deux types d'intégration sont possibles selon le mode de couplage entre le laser et le photodétecteur :

a) - <u>couplage à travers un guide</u> :
Dans ce cas, la double hétérostructure est constituée, d'une part. des différentes couches habituelles (première couche de confinement, couche active, deuxième couche de confinement et couche de contact) et, d'autre part, d'un guide passif situé sous la première couche de confinement. Son indice a une valeur intermédiaire entre celui de la zone active et celui de la couche de confinement. L'attaque des différentes couches est alors arrêtée juste en-dessous de la zone active, dans la première couche de confinement. Le coupla ge entre les deux composants s'effectue à travers le guide et dépend de l'épaisseur de la première couche de confinement ainsi que du profil de l'ouverture réalisée. Un tel mode de couplage est décrit dans l'article de J.L. MERZ et L.R. LOGAN intitulé "Integrated GaAs-GaAlAs injection laser and detector with etched reflector" publié dans Applied Physics Letters, vol. 30, n°10, page 530, 15 mai 1977 et dans l'article de P.D. WRIGHT, R.J. NELSON, R.B. WILSON, intitulé "Monolithic Integration of InGaAsP Heterostructure Lasers and Electrooptical Devices" publié dans IEEE Journal of Quantuum Electron. Vol. QE 18, n°2, février 1982.

b) - <u>Couplage direct</u> :
La double hétérostructure ne comporte pas nécessairement de guide passif sous la couche active. L'ouverture pratiquée est suffisamment profonde pour supprimer tout couplage guidé entre le laser et le détecteur. Deux sections de couche active sont alors face à face : l'une pour l'émission, l'autre pour la détection. Un dispositif de ce type est décrit dans l'article de O. WADA et al intitulé "AlGaAs-GaAs Microcleaved Facet (MCF) Laser Monolithically integrated with photodiode", publié dans Electronic Letters, vol. 18, n°5, 4 mars 1982 et dans l'article de Yoshia Suzuki and al., intitulé "InP/InGaIs 1.5 μm Region etching cavity laser" Jpn.J. Appl. Phys. vol. 23, (1984).

2. La deuxième voie possible est celle d'une intégration hybride. Une telle solution est décrite dans le brevet américain n°93826 "Hybrid semiconductor Laser/detectors" délivré à D.R. SCIFRES et al. Dans cette technique, le laser est monté sur un support en silicium usiné et diffusé pour réaliser un détecteur en face duquel le laser est prépositionné. Un ensemble rigide laser-photodétecteur est ainsi obtenu.

Si elles donnent satisfaction à certains égards, ces techniques présentent néanmoins toutes des inconvénients. D'une façon générale, les structures intégrées laser-photodétecteur sont, par principe montées, côté substrat, sur un dissipateur thermique destiné à réduire leur température de fonctionnement. La résistance thermique non négligeable de ces lasers suppose que ceux-ci aient un courant de seuil faible pour permettre un fonctionnement en continu. Par ailleurs, une bonne sensibilité du système de contre-réaction (rapport de la variation du courant photodétecté à celle du courant d'alimentation du laser) est souhaitable.

Dans le cas de la solution utilisant un guide passif, le courant de seuil est doublé par rapport à un laser isolé à deux faces clivées (6 kA/cm² au lieu de 3 kA/cm²). Cette structure nécessite en outre un contrôle très précis de la gravure des miroirs pour ne pas que le guide optique soit attaqué. Aucune caractéristique en continu n'est fournie par les rapporteurs de cette technique. Les valeurs de sensibilité mesurées sont de l'ordre de 10%.

La structure intégrée à couplage direct permet d'obtenir des courants de seuil relativement faibles (de l'ordre de 40 mA) grâce essentiellement à la qualité des faces microclivées. En revanche, la valeur de la sensibilité reste faible (environ 1,5%). Ceci est dû à la faible surface active de détection (épaisseur de la couche active d'environ 10 nm). La sensibilité est encore plus faible dans le cas des doubles hétérostructures à couches quantiques (épaisseur d'environ 10 mm) et sensibilité de l'ordre de 0,045%.

La structure hybride laser-photodétecteur rassemble l'ensemble des performances souhaitées : bonne qualité des faces miroirs des lasers (faces clivées) et forte sensibilité du détecteur (détecteur au silicium). Mais les limitations de cette technique tiennent à l'hybridation qui pose des problèmes de précision, de fiabilité et de coût de montage.

L'invention a justement pour but de remédier à ces inconvénients en proposant un ensemble laser-photodétecteur intégré monolithiquement sur un même substrat et présentant un faible courant de seuil et une grande sensibilité différentielle.

Ce but est atteint grâce à la mise en oeuvre d'une seule et même technique pour réaliser le ruban laser, l'une des faces réfléchissantes du laser et l'emplacement du photodétecteur. L'invention conduit à un ensemble fiable et performant et permet d'abaisser le coût des têtes optiques pour télécommunications.

De façon précise, l'invention a pour objet un procédé de réalisation d'une structure intégrée laser-photodétecteur, dans lequel :
- on dépose sur un substrat une couche tampon puis une double hétérostructure comprenant une première couche de confinement, une couche active, une seconde couche de confinement,
- on attaque une partie de cette double hétérostructure pour créer une face non clivée servant de face réfléchissante pour le laser,
- on réalise, à proximité du laser et du côté de la face non clivée, un photodétecteur,
ce procédé étant caractérisé par le fait que, pour réaliser le photodétecteur, on attaque une partie de la double hétérostructure au moins jusqu'à la couche tampon et l'on crée le photodétecteur sur la couche tampon ainsi dégagée.

Dans une variante de réalisation, le photodétecteur est obtenu par un contact Schottky. Dans une autre variante, le photodétecteur est une jonction p-n.

Le substrat peut être plan ou présenter un profil en marche d'escalier, ce qui permet de surélever le photodétecteur.

De toute façon, les caractéristiques de l'invention apparaîtront mieux après la description qui va suivre. d'exemples de réalisation donnés à titre explicatif et nullement limitatif. Cette description se réfère à des dessins annexés sur lesquels :

- la figure 1 montre un premier mode de réalisation du procédé de l'invention utilisant un détecteur Schottky,

- la figure 2 montre une variante dans laquelle le substrat présente une forme de marche,

- la figure 3 montre un autre mode de réalisation utilisant un substrat semi-isolant,

- la figure 4 illustre une variante dans laquelle le photodétecteur est une jonction p-n.

L'invention sera décrite dans le cas des matériaux GaAs-GaAlAs sur substrat n+. Cette description s'étend directement aux lasers formés sur substrat semi-isolant et sur des matériaux tels que InP-GaInAsP.

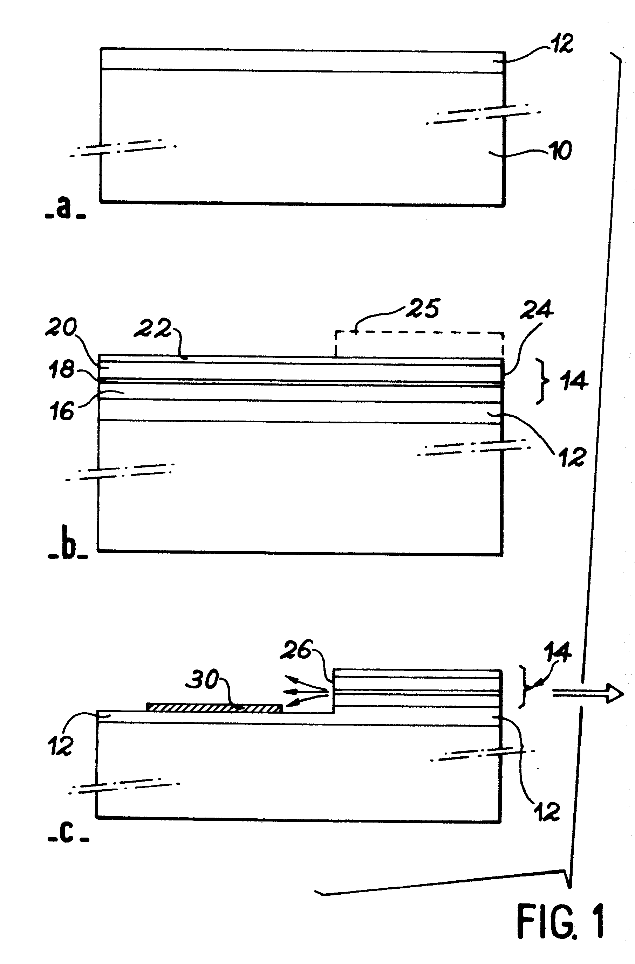

On forme d'abord sur un substrat 10, une couche tampon 12 de type n dopé à $10^{16}$-$10^{17}$ cm$^{-3}$ (partie a de la figure 1). Puis on forme une double hétérostructure, c'est-à-dire un empilement des couches suivantes :
- une première couche de confinement 16 dopée n en $Al_xGa_{1-x}As$ avec $x = 0,3$,
- une couche active 18, non dopée, en $Al_yGa_{1-y}As$ avec $y \leq 0,1$,
- une seconde couche de confinement 20 dopée en $Al_xGa_{1-x}As$ avec $x = 0,3$,
- une couche 22 dopée p+ en GaAs.

Dans le cas de structures quantiques (x de l'ordre de 0,6), la couche active 18 est constituée d'un ou plusieurs puits d'épaisseur de l'ordre de 10 nm.

Le ruban laser définissant latéralement les limites de guide est réalisé soit lors de la croissance, soit après croissance (par implantation de protons).

La face 24 de la double hétérostructure est clivée. On obtient une structure telle que représentée en coupe sur la partie b de la figure 1. Une face non clivée 26 est réalisée en attaquant les matériaux à travers un masque 25 jusqu'à une épaisseur suffisante pour dégager la couche tampon 12. Cette attaque peut être chimique, ionique ou réactive (RIE). La couche tampon dégagée va constituer la couche sensible du photodétecteur.

Un détecteur Schottky est alors réalisé à l'arrière de la face laser non clivée 26, par le dépôt d'une couche métallique 30. Cette couche peut être en alliage Ti/Au. La distance laser-détecteur est de l'ordre de 50 μm.

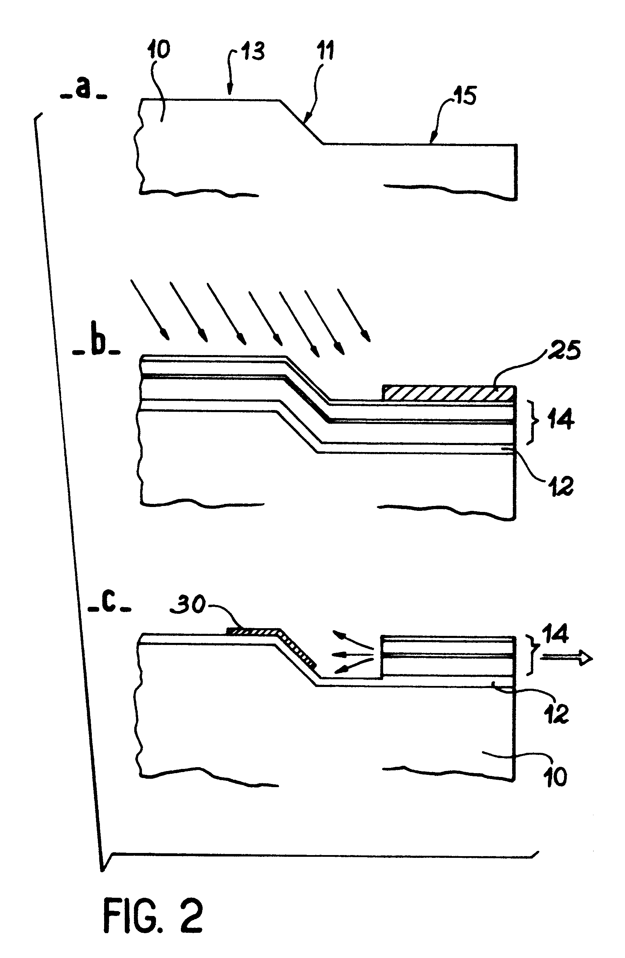

Comme illustré sur la figure 2, on peut aussi partir d'un substrat 10 présentant une forme d'escalier avec une rampe 11 joignant une marche supérieure 13 à une marche inférieure 15 (partie a). L'angle de la rampe peut être de 40 à 50°. Ce substrat peut être réalisé par attaque chimique ou ionique. Dans ce cas, la double hétérostructure 14 est déposée par OMCVD (Organo Metallic Chemical Vapor Deposition) ou par MBE (Molecular Beam Epitaxy). Comme dans le cas précédent, à travers un masque 25 déposé sur une partie de la double hétérostructure. on attaque les couches déposées sur la marche supérieure et sur la zone inclinée jusqu'à la couche tampon 12 (partie _b_ de la figure 2).

Une métallisation 30 est ensuite déposée à cheval sur la marche supérieure et sur la zone inclinée.

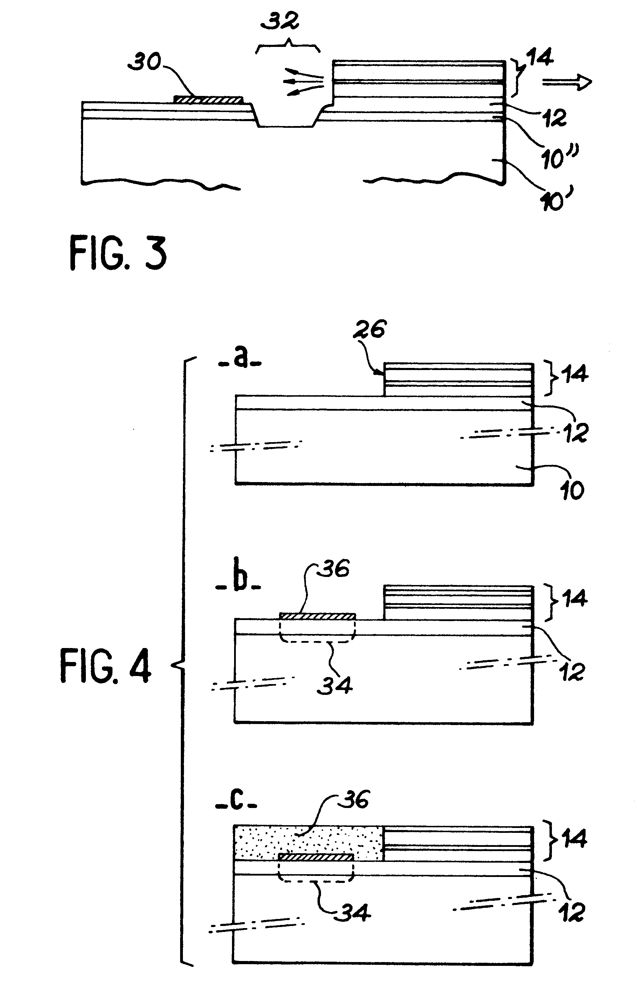

L'invention peut être appliquée également au cas d'un substrat semi-isolant comme illustré sur la figure 3. Ce substrat 10' est surmonté d'une couche 10" dopée N+. L'attaque de la double hétérostructure est poursuivie jusqu'au substrat dans la zone intercalaire 32, pour isoler électriquement le laser du photodétecteur.

Dans les exemples qui précèdent, le photodétecteur est constitué par un contact Schottky. Mais l'invention ne se limite pas à ce cas. On peut fort bien réaliser une jonction p-n comme illustré sur la figure 4.

La première étape (a) est la même que précédemment, si ce n'est que la face décapée 26 du laser est réalisée avant la formation du ruban et des métallisations. Une implantation et un recuit, ou bien une diffusion d'une impureté de type p sélective, sont ensuite réalisés sur la couche tampon 12 dans une zone 34. Une métallisation 36 est ensuite effectuée par la technique du "lift off" (4b).

Le ruban laser est ensuite formé par exemple par implantation par des protons en masquant par une résine 36 toute la région du détecteur jusqu'au sommet de la face usinée (figure 4c).

Cette suite d'opérations peut s'effectuer aussi bien sur un plan (comme illustré) que sur une marche (comme pour la figure 2). De même, le substrat peut être semiconducteour ou semi-isolant (comme sur la figure 3).

Dans les exemples qui viennent d'être décrits, le substrat 10 et la couche tampon 12 servant au photodétecteur sont en GaAs. Si l'on utilise un substrat en InP, il faudra épitaxier une couche en InGaAsP dont la largeur de bande interdite est inférieure ou égale à celle de la couche active, et ceci avant d'épitaxier la couche de confinement en InP.

## Revendications

1. Procédé de réalisation d'une structure intégrée laser-photodétecteur, dans lequel :
- on dépose sur un substrat (10) une couche tampon (12) puis une double hétérostructure (14) comprenant une première couche de confinement (16), une couche active (18), une seconde couche de confinement (20),
- on attaque une partie de cette double hétérostructure pour créer une face non clivée (26) servant de face réfléchissante au laser,
- on réalise, proximité du laser et du côté de la face non clivée, un photodétecteur,
caractérisé par le fait que pour réaliser ce photodétecteur, on attaque une partie de la double hétérostructure au moins jusqu'à la couche tampon (12) et l'on crée le photodétecteur sur la couche tampon ainsi dégagée.

2. Procédé selon la revendication 1, caractérisé par le fait que l'on dépose sur la couche tampon ainsi dégagée une couche métallique (30) formant avec cette couche tampon un détecteur Schottky.

3. Procédé selon la revendication 1, caractérisé par le fait que l'on réalise un dopage d'une zone (34) de la couche tampon ainsi dégagée avec une impureté d'un type de dopage opposé à celui du substrat puis on dépose une couche métallique (36) sur la zone ainsi dopée pour constituer un photodétecteur à jonction.

4. Procédé selon l'une quelconque des revendications 2 et 3, caractérisé par le fait que la double hétérostructure est déposée sur un substrat (10) en forme d'escalier avec une marche supérieure (13) et une marche inférieure (15), reliées par une zone inclinée (11), le laser étant constitué sur la marche inférieure (15) et le photodétecteur en partie sur la marche supérieure (13) et sur la zone inclinée (11).

5. Procédé selon l'une quelconque des revendications 2 et 3, caractérisé par le fait que le substrat (10') étant semi-isolant et recouvert d'une couche dopée (10"), on poursuit l'attaque de la double hétérostructure dans une zone (32) située entre le laser et le photodétecteur jusqu'au substrat semi-isolant.

0222639

_a_

12

10

_b_

20 22 25 24

18 14

16 12

_c_

30 26 14

12 12

FIG. 1

_a_

10  13  11  15

_b_

25

14

12

_c_

30

14

12

10

FIG. 2

FIG. 3

FIG. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| X | IEE PROCEEDINGS, vol. 131, Pt, H, no. 5, octobre 1984, pages 299-303, Hitchin, GB; H. MATSUEDA et al.: "An optoelectronic integrated device including a laser and its driving circuit" * Figure 3; pages 299-300 * | 1-4 | H 01 L  27/15 <br> H 01 S   3/19 <br> H 01 L  31/16 <br> H 01 L  33/00 |
| X | PATENTS ABSTRACTS OF JAPAN, vol. 8, no. 70 (E-235)[1507], 3 avril 1984; & JP-A-58 220 469 (FUJITSU K.K.) 22-12-1983 * Résumé * | 1,3 | |
| Y | US-A-4 297 653  (D.R. SCIFRES et al.) * figures 1-9; revendications * | 1-5 | DOMAINES TECHNIQUES RECHERCHES (Int. Cl.4) |
| Y | US-A-4 352 116  (YARIV et al.) * En entier * | 1-5 | H 01 L <br> H 01 S |
| A | PATENTS ABSTRACTS OF JAPAN, vol. 7, no. 272 (E-214)[1417], 3 décembre 1983; & JP-A-58 154 286 (FUJITSU K.K.) 13-09-1983 * Résumé * | 1-4 | |

--- -/-

Le présent rapport de recherche a été établi pour toutes les revendications

| Lieu de la recherche | Date d'achèvement de la recherche | Examinateur |
|---|---|---|
| LA HAYE | 05-01-1987 | GALLO G.G. |

## DOCUMENTS CONSIDERES COMME PERTINENTS

Page  2

| Catégorie | Citation du document avec indication, en cas de besoin, des parties pertinentes | Revendication concernée | CLASSEMENT DE LA DEMANDE (Int Cl.4) |
|---|---|---|---|
| A | GaAs IC Symposium, Technical Digest, 25-27 octobre 1983, pages 44-47, IEEE; M.E. KIM et al.: "GaAlAs/GaAs integrated optoelectronic transmitter using selective MOCVD epitaxy and planar ion implantation" * Figure 1; page 45 * | 1-4 | |
| A | APPLIED PHYSICS LETTERS, vol. 35, no. 1, juillet 1979, pages 16-18, American Institute of Physics; D.R. SCIFRES et al.: "Semiconductor laser with integral light intensity detector" * Résumé; figure 1 * | 1,2 | |
| A | ELECTRONICS INTERNATIONAL, vol. 56, no. 18, juin 1983, pages 89-90, New York, US; C. COHEN: "Optoelectronic chip integrates laser and pair of FETs" * En entier * | 1-4 | DOMAINES TECHNIQUES RECHERCHES (Int. Cl.4) |

--- -/-

Le présent rapport de recherche a été établi pour toutes les revendications

| Lieu de la recherche | Date d'achèvement de la recherche | Examinateur |
|---|---|---|
| LA HAYE | 05-01-1987 | GALLO G.G. |

## RAPPORT DE RECHERCHE EUROPEENNE

**Office européen des brevets**

Numero de la demande

EP 86 40 2233

### DOCUMENTS CONSIDERES COMME PERTINENTS

Page 3

| Catégorie | Citation du document avec indication, en cas de besoin, des parties pertinentes | Revendication concernée | CLASSEMENT DE LA DEMANDE (Int. Cl.4) |
|---|---|---|---|
| A | APPLIED PHYSICS LETTERS, vol. 43, no. 4, 15 août 1983, pages 345-347, American Institute of Physics, New york, US; O. WADA et al.: "Monolithic integration of a double heterostructure light-emitting diode and a field-effect transistor amplifier using molecular beam grown AlGaAs/GaAs" * En entier * | 1-5 | |
| | ----- | | |
| | | | **DOMAINES TECHNIQUES RECHERCHES (Int. Cl.4)** |

Le present rapport de recherche a été établi pour toutes les revendications

| Lieu de la recherche | Date d'achèvement de la recherche | Examinateur |
|---|---|---|
| LA HAYE | 05-01-1987 | GALLO G.G. |